# EUROPEAN PATENT APPLICATION

(11) **EP 4 415 055 A1**
(43) Date of publication of application: **14.08.2024**
(21) Application number: 24156991.2
(22) Date of filing: 12.02.2024
(51) Int. Cl.: H01L 29/78, H01L 29/423

(54) **SEMICONDUCTOR DEVICE**

(30) Priority: 13.02.2023 JP 2023019998
(71) Applicant: Seiko Epson Corporation, Tokyo 160-8801 (JP)
(72) Inventor: NAKAGAWA, Yohei, Suwa-shi, 392-8502 (JP)
(74) Representative: Lewis Silkin LLP

(57) **Abstract**

A semiconductor device includes a column portion including a source portion and a drain portion constituted by semiconductors having the same conductivity type, a channel portion provided between the source portion and the drain portion and constituted by a semiconductor having a lower impurity concentration than those of the source portion and the drain portion, and a drift portion provided between the channel portion and the drain portion and constituted by a semiconductor having the same conductivity type as that of the drain portion; and a gate electrode provided at a sidewall of the column portion at the channel portion via an insulating portion and configured to control the current of the channel portion. The diameter of the column portion at the drift portion is larger than the diameter of the column portion at the channel portion and the diameter of the column portion at the source portion.

## Description

The present application is based on, and claims priority from JP Application Serial Number 2023-019998, filed February 13, 2023, the disclosure of which is hereby incorporated by reference herein in its entirety.

### BACKGROUND

### 1. Technical Field

The present disclosure relates to a semiconductor device.

### 2. Related Art

Semiconductor nanocolumns are expected to be applied to semiconductor devices such as transistors as next-generation nanodevices.

For example, JP-T-2014-503998 describes a transistor device including a nanowire and a gate surrounding the nanowire.

In the transistor device as described above, it is desired to increase an on/off current ratio while reducing an on-resistance.

### SUMMARY

In an aspect of the present disclosure, a semiconductor device includes a column portion including a source portion and a drain portion constituted by semiconductors having the same conductivity type, a channel portion provided between the source portion and the drain portion and constituted by a semiconductor having a lower impurity concentration than impurity concentrations of the source portion and the drain portion, and a drift portion provided between the channel portion and the drain portion and constituted by a semiconductor having the same conductivity type as that of the drain portion, and a gate electrode provided at a sidewall of the column portion at the channel portion via an insulating portion and configured to control a current of the channel portion, in which a diameter of the column portion at the drift portion is larger than a diameter of the column portion at the channel portion and a diameter of the column portion at the source portion.

### BRIEF DESCRIPTION OF THE DRAWINGS

FIG. 1 is a cross-sectional view schematically illustrating a semiconductor device according to an embodiment.
FIG. 2 is a cross-sectional view schematically illustrating a manufacturing step of the semiconductor device according to the embodiment.
FIG. 3 is a cross-sectional view schematically illustrating a manufacturing step of the semiconductor device according to the embodiment.
FIG. 4 is a cross-sectional view schematically illustrating a manufacturing step of the semiconductor device according to the embodiment.
FIG. 5 is a cross-sectional view schematically illustrating a manufacturing step of the semiconductor device according to the embodiment.
FIG. 6 is a cross-sectional view schematically illustrating a manufacturing step of the semiconductor device according to the embodiment.
FIG. 7 is a cross-sectional view schematically illustrating a manufacturing step of the semiconductor device according to the embodiment.

### DESCRIPTION OF EMBODIMENTS

A preferred embodiment of the present disclosure will be described in detail below with reference to the drawings. Note that the embodiment described below does not unduly limit the content of the present disclosure described in the claims. In addition, not all the configurations described below are essential constituent elements of the present disclosure.

### 1. Semiconductor Device

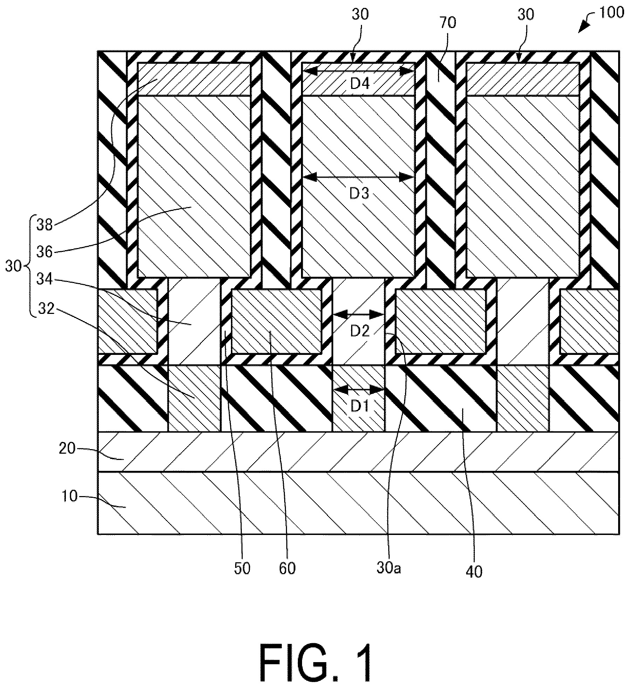

First, a semiconductor device according to an embodiment will be described with reference to the drawings. FIG. 1 is a cross-sectional view schematically illustrating a semiconductor device 100 according to the embodiment.

As illustrated in FIG. 1, the semiconductor device 100 includes, for example, a substrate 10, a buffer layer 20, a column portion 30, a first insulating layer 40, an insulating portion 50, a gate electrode 60, and a second insulating layer 70. The semiconductor device 100 is, for example, a vertical metal-oxide-semiconductor field effect transistor (MOSFET).

The substrate 10 is, for example, an Si substrate, a GaN substrate, a sapphire substrate, or an SiC substrate.

The buffer layer 20 is provided on the substrate 10. The buffer layer 20 is, for example, an n-type GaN layer doped with Si. Note that although not illustrated, a mask layer for growing the column portion 30 may be provided on the buffer layer 20. The mask layer is, for example, a titanium layer, a silicon oxide layer, a titanium oxide layer, an aluminum oxide layer, or the like.

Note that in the present specification, a description is given with a layering direction of a source portion 32 and a channel portion 34 of the column portion 30 (hereinafter, may be simply referred to as a "layering direction") defined based on the channel portion 34. Specifically, a direction from the channel portion 34 toward a drain portion 38 of the column portion 30 is defined as "upward" and a direction from the channel portion 34 toward the source portion 32 is defined as "downward".

The column portion 30 is provided on the buffer layer 20. The column portion 30 is provided at the substrate 10 via the buffer layer 20. The column portion 30 has a columnar shape protruding upward from the buffer layer 20. In other words, the column portion 30 protrudes upward from the substrate 10 via the buffer layer 20. The columnar portion 30 is also called, for example, a nanocolumn, a nanowire, a nanorod, or a nanopillar. The planar shape of the column portion 30 is, for example, a polygon such as a hexagon or a circle.

The diameter of the column portion 30 is, for example, 50 nm or more and 500 nm or less, and may be 100 nm or more and 300 nm or less. With the column portion 30 having a diameter of 500 nm or less, the column portion 30 of high-quality crystal can be obtained.

Note that the "diameter of the columnar portion 30" is a diameter when the planar shape of the columnar portion 30 is a circle, and is a diameter of the minimum inclusion circle when the planar shape of the columnar portion 30 is a shape other than a circle. For example, when the planar shape of the columnar portion 30 is a polygon, the diameter of the columnar portion 30 is the diameter of the smallest circle that includes the polygon therein. When the planar shape of the columnar portion 30 is an ellipse, the diameter of the columnar portion 30 is the diameter of the smallest circle that includes the ellipse therein.

For example, a plurality of the column portions 30 are provided. By including the plurality of column portions 30, the semiconductor device 100 can achieve a large current, and is thus suitably used as a power device. The plurality of columnar portions 30 are separated from each other. An interval between adjacent ones of the column portions 30 is, for example, 10 nm or more and 1 µm or less, and may be 25 nm or more and 750 nm or less. The plurality of column portions 30 are arrayed at a predetermined pitch in a predetermined direction when viewed in the layering direction. The plurality of column portions 30 are arrayed in, for example, a triangular lattice pattern or a square lattice pattern.

Note that the "pitch of the columnar portions 30" is a distance between the centers of adjacent ones of the columnar portions 30 in the predetermined direction. The "center of the columnar portion 30" is a center of a circle when the planar shape of the columnar portion 30 is the circle, and is a center of the minimum inclusion circle when the planar shape of the columnar portion 30 is a shape other than a circle. For example, when the planar shape of the columnar portion 30 is a polygon, the center of the columnar portion 30 is the center of the smallest circle that includes the polygon therein. When the planar shape of the columnar portion 30 is an ellipse, the center of the columnar portion 30 is the center of the smallest circle that includes the ellipse therein.

The column portion 30 includes the source portion 32, a channel portion 34, a drift portion 36, and the drain portion 38. The source portion 32, the channel portion 34, the drift portion 36, and the drain portion 38 are constituted by, for example, a group III nitride semiconductor, and each have a wurtzite crystal structure.

The source portion 32 is provided on the buffer layer 20. The source portion 32 is provided between the buffer layer 20 and the channel portion 34. The material of the source portion 32 is, for example, n-type GaN doped with Si. The impurity concentration of the source portion 32 may be the same as the impurity concentration of the buffer layer 20.

The channel portion 34 is provided on the source portion 32. The channel portion 34 is provided between the source portion 32 and the drain portion 38. The channel portion 34 is provided between the source portion 32 and the drift portion 36. The impurity concentration of the channel portion 34 is lower than the impurity concentration of the source portion 32 and the impurity concentration of the drain portion 38. The impurity concentration of the channel portion 34 is, for example, lower than the impurity concentration of the drift portion 36. The impurity concentrations of the source portion 32, the channel portion 34, the drift portion 36, and the drain portion 38 are measured by, for example, atom probe analysis.

The material of the channel portion 34 is, for example, unintentionally doped (UID)-type GaN in which impurities are not intentionally doped, or n-type GaN. A channel is formed at the channel portion 34 by applying a predetermined voltage to the gate electrode 60. For example, an N-channel is formed at the channel portion 34.

The drift portion 36 is provided on the channel portion 34. The drift portion 36 is provided between the channel portion 34 and the drain portion 38. The conductivity type of the drift portion 36 is, for example, the same as the conductivity type of the source portion 32 and the drain portion 38. The material of the drift portion 36 is, for example, n-type GaN doped with Si.

The impurity concentration of the drift portion 36 is lower than the impurity concentration of the source portion 32 and the impurity concentration of the drain portion 38. The drift portion 36 improves pressure resistance of the semiconductor device 100 in an off state.

A diameter D3 of the column portion 30 at the drift portion 36 is larger than a diameter D2 of the column portion 30 at the channel portion 34 and a diameter D1 of the column portion 30 at the source portion 32. The diameter D2 is, for example, the same as the diameter D1. The diameter D3 is, for example, the same as a diameter D4 of the column portion 30 at the drain portion 38. In the illustrated example, the diameter of the column portion 30 at the source portion 32 is constant in the layering direction. The diameter of the column portion 30 at the channel portion 34 is constant in the layering direction. The diameter of the column portion 30 at the drift portion 36 is constant in the layering direction. The diameter of the column portion 30 at the drift portion 38 is constant in the layering direction. In the illustrated example, the diameter D1 is the maximum width of the column portion 30 at the source portion 32. The diameter D2 is the maximum width of the column portion 30 at the channel portion 34. The diameter D3 is the maximum width of the column portion 30 at the drift portion 36. The diameter D4 is the maximum width of the column portion 30 at the drain portion 38. The diameters D1, D2, D3, and D4 are measured by, for example, a scanning electron microscope (SEM) or a transmission electron microscope (TEM).

The drain portion 38 is provided on the drift portion 36. The conductivity type of the drain portion 38 is the same as the conductivity type of the source portion 32. The material of the drain portion 38 is, for example, n-type GaN doped with Si.

The impurity concentration of the drain portion 38 may be the same as the impurity concentration of the source portion 32. The source portion 32, the channel portion 34, the drift portion 36, and the drain portion 38 are arranged in this order in the layering direction.

The first insulating layer 40 is provided on the buffer layer 20, for example. The first insulating layer 40 is provided between the buffer layer 20 and the gate electrode 60. The first insulating layer 40 is provided between the source portions 32 of adjacent ones of the column portions 30. The first insulating layer 40 surrounds the source portion 32 when viewed in the layering direction. The first insulating layer 40 is, for example, a spin-on-glass (SOG) layer.

The insulating portion 50 is provided at a sidewall 30a of the column portion 30 at the channel portion 34, the drift portion 36, and the drain portion 38. The insulating portion 50 is further provided at the upper surface of the first insulating layer 40 and the upper surface of the column portion 30. The sidewall 30a is constituted by, for example, m surfaces. In the illustrated example, in the layering direction, a position of a boundary between the insulating portion 50 and the first insulating layer 40 is the same as the position of the boundary between the channel portion 34 and the source portion 32. The insulating portion 50 is provided between the channel portion 34 and the gate electrode 60. A portion of the insulating portion 50 provided between the channel portion 34 and the gate electrode 60 serves as a gate insulating layer. The insulating portion 50 surrounds the channel portion 34 when viewed in the layering direction. The material of the insulating layer 50 is, for example, silicon oxide.

The gate electrode 60 is provided at the sidewall 30a of the column portion 30 in the channel portion 34 via the insulating portions 50. The gate electrode 60 is provided between the channel portions 34 of adjacent ones of the column portions 30. The gate electrode 60 surrounds the column portion 30 and the insulating portion 50 when viewed in the layering direction. The semiconductor device 100 has a gate all around (GAA) structure. The material of the gate electrode 60 is, for example, polysilicon doped with impurities such as phosphorus or boron, or a metal. The gate electrode 60 controls the current of the channel portion 34.

The second insulating layer 70 is provided on the gate electrode 60. The second insulating layer 70 is provided between the drift portions 36 and between the drain portions 38 of adjacent ones of the column portions 30. The second insulating layer 70 surrounds the drift portion 36 and the drain portion 38 when viewed in the layering direction. The material of the second insulating layer 70 is, for example, the same as that of the first insulating layer 40.

The semiconductor device 100 is, for example, a power device used for controlling or supplying electric energy. The semiconductor device 100 is applied to, for example, an inverter, a charger, a booster, a step-down transformer, a direct current (DC)/DC converter, an electric aircraft, an electric vehicle, and the like.

The semiconductor device 100 has, for example, the following operations and effects.

The semiconductor device 100 includes the column portion 30 including the source portion 32 and the drain portion 38 constituted by semiconductors having the same conductivity type, the channel portion 34 provided between the source portion 32 and the drain portion 38 and constituted by a semiconductor having an impurity concentration lower than those of the source portion 32 and the drain portion 38, and the drift portion 36 provided between the channel portion 34 and the drain portion 38 and constituted by a semiconductor having the same conductivity type as that of the drain portion 38. Further, the semiconductor device 100 includes the gate electrode 60 that is provided at the sidewall 30a of the column portion 30 in the channel portions 34 via the insulating portions 50 and that controls the current of the channel portion 34. The diameter D3 of the column portion 30 at the drift portion 36 is larger than the diameter D2 of the column portion 30 at the channel portion 34 and the diameter D1 of the column portion 30 at the source portion 32.

Thus, in the semiconductor device 100, it is possible to reduce an on-resistance as compared with a case in which the diameter D3 is equal to the diameters D1 and D2. Further, in the semiconductor device 100, since the diameter D2 is smaller than the diameter D3, the channel portion 34 is easily completely depleted. As a result, an on/off current ratio can be increased. The "on/off current ratio" is a ratio of a current value in an on state with respect to a current value in the off state. As described above, in the semiconductor device 100, it is possible to increase the on/off current ratio while reducing the on-resistance. For example, the semiconductor device 100 can realize a normally-off state in which the semiconductor device 100 is turned off at a gate voltage of 0V.

Further, in the semiconductor device 100, since the diameter D1 is smaller than the diameter D3, for example, it is possible to reduce the possibility of dislocations caused by a difference in lattice constant between the substrate 10 and the buffer layer 20 reaching the channel portion 34.

In the semiconductor device 100, the gate electrode 60 surrounds the channel portion 34. Thus, in the semiconductor device 100, the channel portion 34 is easily completely depleted.

In the semiconductor device 100, the impurity concentration of the drift portion 36 is lower than the impurity concentration of the drain portion 38. Thus, in the semiconductor device 100, the pressure resistance can be improved.

### 2. Manufacturing Method of Semiconductor Device

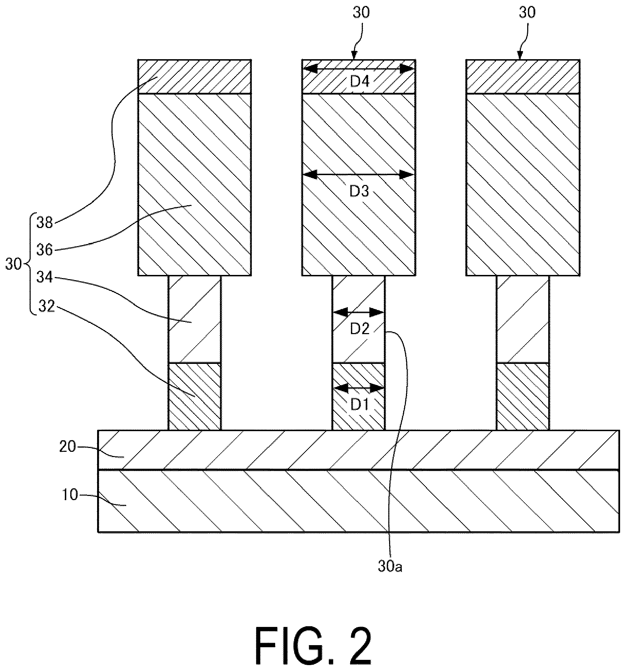

Next, a manufacturing method of the semiconductor device 100 according to the embodiment will be described with reference to the drawings. FIGS. 2 to 7 are cross-sectional views schematically illustrating manufacturing steps of the semiconductor device 100 according to the embodiment.

As illustrated in FIG. 2, the buffer layer 20 is epitaxially grown on the substrate 10. Examples of the epitaxial growth method include a metal organic chemical vapor deposition (MOCVD) method and a molecular beam epitaxy (MBE) method.

Subsequently, a mask layer (not illustrated) is formed on the buffer layer 20. Subsequently, the source portion 32, the channel portion 34, the drift portion 36, and the drain portion 38 are epitaxially grown in this order on the buffer layer 20 using the mask layer as a mask. Examples of the epitaxial growth method include an MOCVD method and an MBE method. By adjusting film forming conditions such as a film forming temperature and a film forming speed of the epitaxial growth, the diameters D1, D2, D3, and D4 can be controlled. With this step, the plurality of column portions 30 can be formed.

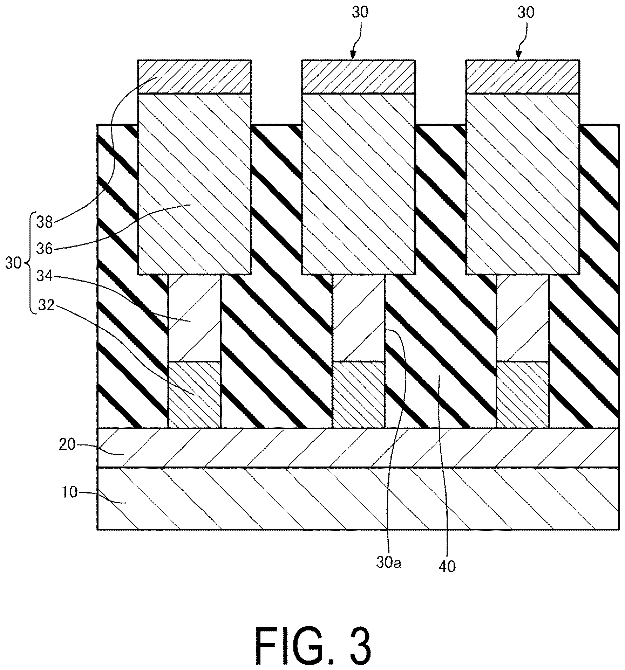

As illustrated in FIG. 3, the first insulating layer 40 is formed between adjacent ones of the column portions 30. In the illustrated example, the first insulating layer 40 is formed between the source portions 32, between the channel portions 34, and between the drift portions 36 of the adjacent ones of the column portions 30. The first insulating layer 40 is formed by an SOG method, an atomic layer deposition (ALD) method, a chemical vapor deposition (CVD) method, or the like, for example.

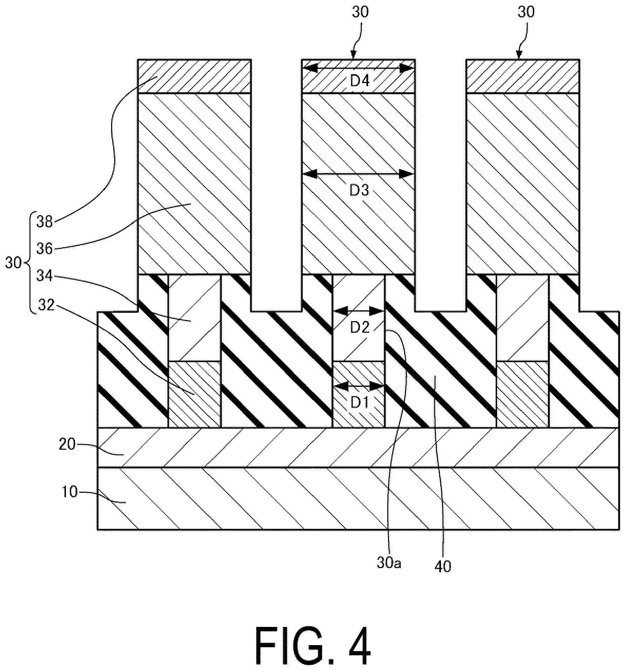

As illustrated in FIG. 4, the first insulating layer 40 is etched to remove the first insulating layer 40 between the drift portions 36 of the adjacent ones of the column portions 30. As the etching, for example, dry etching is used. In this way, the processing time of etching can be shortened as compared with a case in which wet etching is used as the etching. Furthermore, the reproducibility of the shape of the etched first insulating layer 40 can be improved. Since the diameter D3 is larger than the diameter D2, the drift portion 36 serves as an overhang with respect to the channel portion 34 in the dry etching at this step. As a result, damage to the channel portion 34 caused by the dry etching can be reduced.

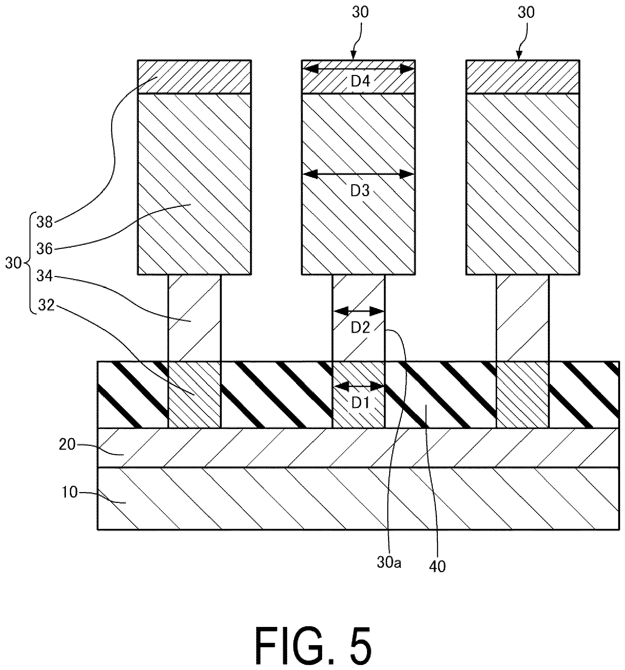

As illustrated in FIG. 5, the first insulating layer 40 is etched to remove the first insulating layer 40 between the channel portions 34 of the adjacent ones of the column portions 30. As the etching, for example, wet etching is used. As a result, the damage to the channel portion 34 can be reduced as compared with a case in which the dry etching is used. Since the diameter D1 is smaller than the diameter D2, etching liquid is likely to be retained around the channel portion 34 in the wet etching at this step. As a result, the first insulating layer 40 between the channel portions 34 of the adjacent ones of the column portions 30 can be efficiently etched.

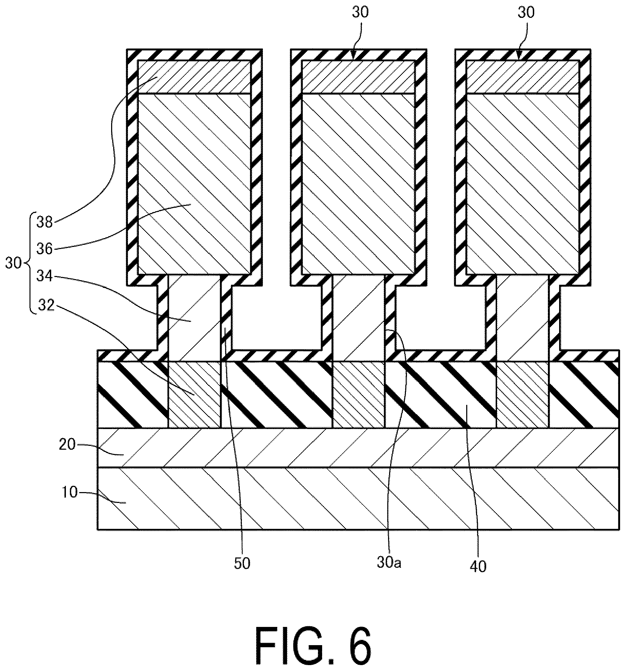

As illustrated in FIG. 6, the insulating portion 50 is formed on the first insulating layer 40 with the insulating portion 50 covering the column portion 30. The insulating layer 50 is formed by an ALD method or a CVD method, for example.

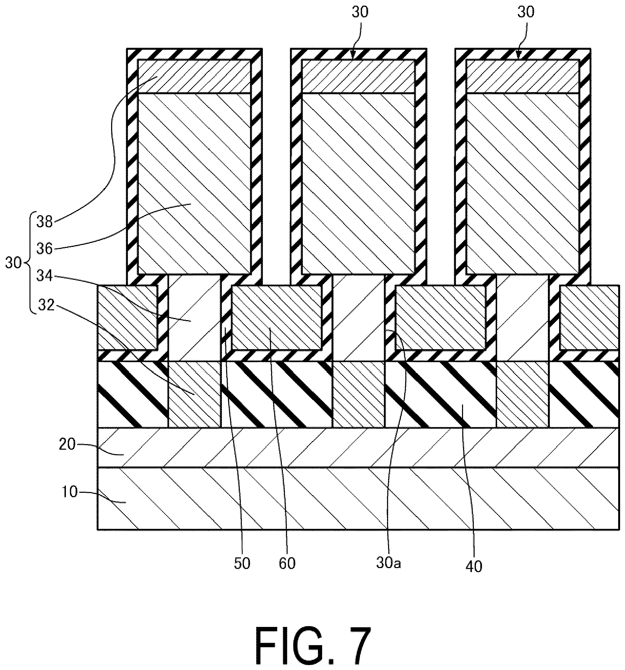

As illustrated in FIG. 7, the gate electrode 60 is formed on the first insulating layer 40 and between the channel portions 34 of the adjacent ones of the column portions 30. The gate electrode 60 is formed by an ALD method, a CVD method, or a vacuum deposition method, for example.

As illustrated in FIG. 1, the second insulating layer 70 is formed on the gate electrode 60 and between the drift portions 36 and between the drain portions 38 of the adjacent ones of the column portions 30. The second insulating layer 70 is formed by, for example, an SOG method, an ALD method, a CVD method, or the like.

The semiconductor device 100 can be manufactured by performing the steps described above.

In the above description, a bottom-up method for epitaxially growing the plurality of column portions 30 on the buffer layer 20 has been described. Note that a method of forming the column portion 30 is not particularly limited, and may be, for example, a top-down method in which a plurality of semiconductor layers are layered to form a layered body and the layered body is etched to form the plurality of column portions 30.

The embodiment and modified examples described above are examples and are not intended as limitations. For example, each embodiment and each modified example can also be combined as appropriate.

The present disclosure includes configurations that are substantially identical to the configurations described in the embodiment, for example, configurations with identical functions, methods, and results, or with identical advantages and effects. Also, the present disclosure includes configurations obtained by replacing non-essential portions of the configurations described in the embodiment. In addition, the present disclosure includes configurations having the same operations and effects or can achieve the same advantages as those of the configurations described in the embodiment. Further, the present disclosure includes configurations obtained by adding known techniques to the configurations described in the embodiment.

The following content is derived from the embodiment and modified examples described above.

In an aspect of the present disclosure, a semiconductor device includes a column portion including a source portion and a drain portion constituted by semiconductors having the same conductivity type, a channel portion provided between the source portion and the drain portion and constituted by a semiconductor having a lower impurity concentration than those of the source portion and the drain portion, and a drift portion provided between the channel portion and the drain portion and constituted by a semiconductor having the same conductivity type as that of the drain portion; and a gate electrode provided at a sidewall of the column portion at the channel portion via an insulating portion and configured to control a current of the channel portion. A diameter of the column portion at the drift portion is larger than a diameter of the column portion at the channel portion and a diameter of the column portion at the source portion.

According to this semiconductor device, it is possible to increase the on/off current ratio while reducing the on-resistance.

In an aspect of the semiconductor device, the gate electrode may surround the channel portion.

According to this semiconductor device, the channel portion is easily completely depleted.

In an aspect of the semiconductor device, an impurity concentration of the drift portion may be lower than an impurity concentration of the drain portion.

According to this semiconductor device, the pressure resistance can be improved.

In an aspect of the semiconductor device, the semiconductor device may be a power device.

## Claims

1. A semiconductor device comprising:
a column portion including
a source portion and a drain portion constituted by semiconductors having the same conductivity type,
a channel portion provided between the source portion and the drain portion and constituted by a semiconductor having a lower impurity concentration than impurity concentrations of the source portion and the drain portion, and
a drift portion provided between the channel portion and the drain portion and constituted by a semiconductor having the same conductivity type as that of the drain portion; and
a gate electrode provided at a sidewall of the column portion at the channel portion via an insulating portion and configured to control a current of the channel portion, wherein
a diameter of the column portion at the drift portion is larger than a diameter of the column portion at the channel portion and a diameter of the column portion at the source portion.

2. The semiconductor device according to claim 1, wherein
the gate electrode surrounds the channel portion.

3. The semiconductor device according to claim 1, wherein
an impurity concentration of the drift portion is lower than the impurity concentration of the drain portion.

4. The semiconductor device according to claim 1, wherein
the semiconductor device is a power device.
